(19) Europäisches Patentamt / European Patent Office / Office européen des brevets

(11) **EP 1 952 171 B1**

(12) **FASCICULE DE BREVET EUROPEEN**

(45) Date de publication et mention
de la délivrance du brevet:
**05.12.2012 Bulletin 2012/49**

(51) Int Cl.:
***G01R 33/421*** *(2006.01)*    ***G01R 33/385*** *(2006.01)*

(21) Numéro de dépôt: **06831308.9**

(22) Date de dépôt: **26.10.2006**

(86) Numéro de dépôt international:
**PCT/FR2006/051116**

(87) Numéro de publication internationale:
**WO 2007/048984 (03.05.2007 Gazette 2007/18)**

(54) **MACHINE DE RMN A BOBINES DE GRADIENT SOLENOIDALES INCORPOREES DANS DES TUBES**

**NMR-MASCHINE MIT IN RÖHREN EINGEBAUTEN ELEKTROMAGNETISCHEN GRADIENTENSPULEN**

**NMR MACHINE COMPRISING SOLENOID GRADIENT COILS WHICH ARE INCORPORATED INTO TUBES**

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **26.10.2005 FR 0510951**

(43) Date de publication de la demande:
**06.08.2008 Bulletin 2008/32**

(73) Titulaire: **Commissariat à l'Énergie Atomique et aux Énergies Alternatives
75015 Paris (FR)**

(72) Inventeur: **AUBERT, Guy
F-86000 Poitiers (FR)**

(74) Mandataire: **Thévenet, Jean-Bruno et al
Cabinet Beau de Loménie
158, rue de l'Université
75340 Paris Cédex 07 (FR)**

(56) Documents cités:
**EP-A- 0 681 189    WO-A-2005/029110
US-A- 5 530 355    US-A1- 2002 105 329**

**Description**

La présente invention concerne une machine de résonance magnétique nucléaire (RMN) à bobines de gradient solénoïdales incorporées dans des tubes, et plus particulièrement une machine de RMN à compensation des courants de Foucault engendrés par les bobines de gradient.

L'invention concerne d'une manière générale une machine de RMN utilisable pour réaliser de l'imagerie par résonance magnétique (IRM) notamment dans le domaine médical.

Des machines de RMN peuvent présenter une structure du type tunnel avec un espace central réservé au patient et une structure annulaire qui doit intégrer d'une part des moyens pour créer dans l'espace central d'observation un champ magnétique principal intense $B_0$, ces moyens étant généralement constitués par une bobine supraconductrice d'aimantation principale disposée dans un cryostat, ou le cas échéant par un aimant permanent, et d'autre part des moyens d'excitation radiofréquence (antennes d'émission) et de traitement des signaux radiofréquence réémis par le corps d'un patient placé dans l'espace central d'observation, en réponse aux séquence d'excitation radiofréquence.

Pour pouvoir différencier les signaux radiofréquence émis en réponse et créer une image, il est en outre mis en oeuvre des bobines, dites bobines de gradient, pour superposer au champ homogène intense principal, des champs magnétiques supplémentaires dont la valeur est fonction des coordonnées dans l'espace de leur lieu d'application.

On organise traditionnellement cette différenciation selon trois axes orthogonaux X, Y, Z, avec l'axe Z qui est généralement pris colinéaire au champ intense $B_0$. Chaque lieu de l'espace peut ainsi être codé à une valeur de champ différente et on exploite dans le signal réémis les modifications qui en résultent pour créer l'image.

L'acquisition d'une image nécessite donc, au cours de l'application des séquences d'excitation radiofréquence, l'application conjointe de séquences de gradient de champ. Quelle que soit la méthode d'imagerie retenue, une caractéristique des gradients de champ est qu'ils sont pulsés.

Divers exemples de systèmes de bobines de gradient pour machines de RMN ont été donnés par exemple dans les documents de brevet FR 2 588 997 et FR 2 621 125. Pour que l'imagerie RMN soit de qualité, il convient que les gradients de champ réels soient homogènes, c'est-à-dire respectent, avec une tolérance donnée, une distribution théorique idéale que l'on voudrait imposer. Pour accroître l'homogénéité des gradients produits, les bobines de gradient doivent être les plus grandes possibles, mais il convient également, pour des questions d'encombrement et de puissance, de ne pas augmenter exagérément la taille de ces bobines de gradient dont la conception est donc soumise à des exigences contradictoires.

Par ailleurs, le caractère temporaire des impulsions de gradient nécessite de résoudre en plus d'un problème de linéarité du champ que ces bobines de gradient procurent, des problèmes liés au caractère pulsé de ce champ.

Ainsi, en particulier, pour des machines de RMN à champ orientateur de forte intensité, il est nécessaire d'avoir des signaux de RMN détectables de fréquence élevée, par exemple de l'ordre de 426 MHz pour des machines de RMN fonctionnant à environ 10 teslas. Les bobines de gradient doivent alors être à même de fournir une pente de gradient par exemple de l'ordre de 100 à 150 milliteslas par mètre.

De tels gradients plus puissants conduisent à plusieurs types de problèmes. Premièrement, la puissance dissipée par les bobines de gradient capables de telles pentes devient très importante : de l'ordre de quelques dizaines de kW. Il convient donc de mettre en place un refroidissement efficace pour que ces gradients ne viennent pas réchauffer le patient et le cryostat dans lequel est contenue la bobine supraconductrice d'aimantation principale.

En outre, dans des séquences d'imagerie utilisées actuellement, des séquences rapides comportent l'application d'impulsions de gradient dont la durée est de l'ordre de quelques millisecondes et dont les temps de montée et de descente doivent être inférieurs ou égaux à la milliseconde.

Avec les puissances électriques mises en jeu, les bobines de gradient se retrouvent alors soumises, dans le champ orienteur de la machine, à des accélérations très violentes dues aux forces électromagnétiques. Ces accélérations provoquent d'une part à court terme la détérioration de la machine et d'autre part la production de bruits insupportables par le patient sous examen. La contrainte de bruit est par ailleurs une contrainte particulièrement néfaste lorsque, notamment dans le cadre de l'examen du cerveau, on cherche à mettre en évidence les zones du cerveau qui sont sollicitées lors d'un exercice intellectuel particulier. Il est alors difficile de demander à un patient de se livrer à un exercice intellectuel particulier (par exemple effectuer des opérations d'addition ou de multiplication mentalement) tout en le soumettant à un bruit trépidant qui gêne sa concentration.

Quand bien même ce type d'expérience serait envisageable avec un être humain, les expériences pré-cliniques effectuées avec des animaux ne sont alors pas possibles si ces animaux sont sollicités par ailleurs par ces bruits.

L'ensemble de ces problèmes doit bien entendu être résolu en tenant compte du fait que l'encombrement des bobines de gradient est limité, pour laisser un volume d'examen utile suffisamment grand. A titre indicatif, on retiendra parce que c'est maintenant une habitude dans le domaine, que le volume utile d'examen se situe dans un tunnel de section circulaire dont le diamètre doit avoir une valeur d'environ 550 millimètres, les bobines de gradient devant tenir dans un espace annulaire compris entre ce volume tunnel utile et le volume à l'intérieur des enveloppes du cryostat. Ce volume intérieur au cryostat dégage un tunnel circulaire d'environ 1000 millimètres de diamètre.

On connaît par le document de brevet US 5 530 355 une machine de RMN dans laquelle, pour réaliser des gradients, on utilise également des bobinages dont les axes sont des génératrices d'un cylindre dont l'axe correspond à la direction du champ magnétique principal. Pour améliorer la linéarité, le document précité préconise cependant d'utiliser des bobinages autres que solénoïdaux, ce qui rend la réalisation plus complexe.

Pour réaliser des gradients tout en prenant en compte les problèmes précédents, on a déjà proposé, dans le document de brevet WO2005/029110, de consacrer l'espace annulaire disponible à la mise en place de tubes dans lesquels sont engagées des bobines solénoïdales circulaires. De préférence, les tubes sont contigus les uns aux autres et forment une nappe de tubes.

La disposition des bobines dans les tubes permet d'aboutir au résultat escompté de grande intensité des gradients produits grâce à des possibilités de refroidissement améliorées, de respect des contraintes de linéarité imposées par les spécifications, de réduction des bruits acoustiques et de limitation des courants de Foucault.

La disparition des bruits provient de la structure solénoïdale des bobines engagées dans des tubes d'axes parallèles au champ principal et de leurs sollicitations uniquement radiales à leur propre structure, le torseur résultant des contraintes électromagnétiques étant nul.

Les structures ainsi préconisées, notamment pour les gradients X et Y, ayant une orientation de champ perpendiculaire aux bobines de gradient classiques produisent dans les écrans ou les différentes enveloppes métalliques du cryostat des courants de Foucault notablement plus faibles que selon les réalisations précédemment connues.

Toutefois, ces courants de Foucault peuvent dans certains cas rester gênants, notamment en provoquant un échauffement exagéré du cryostat, qui augmente la consommation de fluide cryogénique.

Par ailleurs, l'interposition d'écrans classiques entre des générateurs de gradients et le cryostat de l'aimant principal permet de diminuer à l'extérieur de ces écrans les champs électriques produits par les générateurs de gradients.

Toutefois, cette réduction des courants induits diminue l'efficacité des gradients et rend encore plus difficile la réalisation de gradients intenses à commutation rapide dans un champ principal élevé.

Ainsi, les documents de brevets EP 0 681 189 et US 2002/0105329 montrent l'utilisation d'un écran passif en matériau bon conducteur, tel que le cuivre ou l'aluminium, pour protéger l'aimant principal semiconducteur par rapport aux champs magnétiques variables des générateurs de gradients, mais un inconvénient réside dans le fait que l'intensité des gradients est affaiblie et que la linéarité des gradients et la forme temporelle des impulsions de gradient sont perturbées de façon significative.

L'invention a ainsi pour but de remédier aux inconvénients précités et notamment de diminuer les inconvénients liés à la création de courants de Foucault par les générateurs de gradients.

Ces buts sont atteints, conformément à l'invention, grâce à une machine de résonance magnétique nucléaire, comprenant des moyens de création d'un champ magnétique principal intense $B_0$ dans un espace intérieur utile en forme de tunnel d'axe Z, des moyens d'excitation radiofréquence et de traitement des signaux radiofréquence émis en réponse par un corps ou objet disposé dans ledit espace intérieur utile, et un ensemble de bobines de gradient solénoïdales pour superposer au champ magnétique intense $B_0$ des composants d'un champ magnétique supplémentaire, lesdites bobines de gradient étant incorporées dans des tubes disposés dans un espace annulaire cylindrique situé entre une enceinte cryogénique extérieure contenant lesdits moyens de création d'un champ magnétique intense $B_0$ et ledit espace intérieur utile, le diamètre des bobines de gradient étant inscrit dans une épaisseur dudit espace annulaire cylindrique, les bobines de gradient solénoïdales étant adaptées pour produire à la fois un premier gradient de champ X dans une première direction x radiale de la machine perpendiculaire à l'axe Z, et un deuxième gradient de champ Y dans une deuxième direction y radiale de la machine également perpendiculaire à l'axe Z, la première direction x étant perpendiculaire à la deuxième direction y, et la machine comportant des amplificateurs pour alimenter simultanément ces bobines solénoïdales par des sommes algébriques de courants correspondant aux deux gradients, caractérisée en ce qu'une bobine solénoïdale dont le diamètre est inscrit dans l'espace annulaire cylindrique et qui produit un gradient de champ Z dans une direction z parallèle au champ principal $B_0$ est coaxiale avec une autre bobine solénoïdale inscrite dans un même tube de cet espace annulaire cylindrique et produisant un gradient de champ X dans une direction x perpendiculaire à la direction z, en ce qu'elle comprend en outre entre ladite enceinte cryogénique extérieure et ledit espace annulaire cylindrique un écran cylindrique long d'axe Z comprenant un matériau conducteur refroidi à une température inférieure ou égale à 77 K et choisi de manière à présenter une résistivité inférieure ou égale à $10^{-8}$ $\Omega.m$ tel que des courants induits négligeables sont générés dans l'enceinte cryogénique extérieure tandis que les courants de Foucault induits dans l'écran cylindrique contribuent à renforcer les gradients produits par lesdites bobines de gradient solénoïdales.

Contrairement aux écrans traditionnels, l'écran cylindrique préconisé selon l'invention n'atténue pas les courants induits, mais permet de les faire apparaître de façon contrôlée et exactement calculable dans l'écran long, épais et bon conducteur qui est cylindrique avec un axe colinéaire à l'axe Z du champ principal $B_0$.

L'écran cylindrique peut être en aluminium, en cuivre ou encore en un matériau supraconducteur.

L'écran cylindrique conducteur est refroidi à une température inférieure ou égale à 77 K (température de l'azote liquide) ou de préférence à une température comprise entre 20 et 40 K. Une telle plage de température peut être obtenue par exemple par recyclage de vapeurs d'hélium utilisées dans le cryostat.

Selon un mode particulier de réalisation, l'écran cylindrique en matériau conducteur est disposé entre des première et deuxième parois cylindriques en verre époxy, l'écran cylindrique étant maintenu en position par rapport aux première et deuxième parois cylindriques à l'aide de supports isolants localisés.

Avantageusement, l'écran cylindrique comprend de préférence une épaisseur comprise entre 5 et 15 mm.

Selon une particularité avantageuse, qui permet notamment d'offrir plus de place pour les épaules d'une patient ou pour des éléments d'instrumentation, les bobines de gradient solénoïdales incorporées dans des tubes constituent des sources élémentaires de gradients de X, Y et Z qui sont dimensionnées comme faisant partie d'un ensemble de N sources élémentaires contiguës réparties sur le pourtour de l'espace annulaire cylindrique, où $N = 4\upsilon$, $\upsilon$ étant un entier supérieur ou égal à 2 et de préférence compris entre 2 et 4, mais où une source élémentaire sur deux est omise pour ne conserver que $2\upsilon$ sources élémentaires non contiguës, chaque tube étant muni d'une source élémentaire.

Dans le cas où il n'est pas nécessaire de dégager plus de place pour les épaules d'un patient, selon un mode de réalisation possible, les bobines solénoïdales circulaires sont réparties selon le pourtour de l'espace annulaire en 2n arrangements de bobines solénoïdales coaxiales où n est un entier supérieur ou égal à 3, de préférence compris entre 4 et 9.

Selon un autre mode de réalisation possible, les bobines solénoïdales circulaires sont réparties selon le pourtour de l'espace annulaire en 2n arrangements de bobines solénoïdales coaxiales, plusieurs bobines étant alimentées simultanément par des combinaisons de courants pour produire un gradient X et/ou Y et/ou Z, n étant un entier supérieur ou égal à 3, de préférence compris entre 4 et 9.

Selon une variante de réalisation, une composante d'un courant qui passe dans une bobine pour produire un gradient est proportionnelle à un courant nominal multiplié par un cosinus d'un angle de repérage de la bobine sur le pourtour de l'espace annulaire.

Selon une autre variante de réalisation, une composante d'un courant qui passe dans une bobine pour produire un gradient est proportionnelle à un courant nominal multiplié par un coefficient 1, 0,732 ou 0,268, en fonction d'un angle de repérage de la bobine sur le pourtour de l'espace annulaire.

Selon une réalisation particulière, l'espace annulaire comporte plusieurs tubes contigus répartis sur le pourtour pour recevoir les bobines solénoïdales, le rayon a d'un tube étant donné par $a = r1(\sin\pi/N)/(1-\sin\pi/N) = r2(\sin\pi/N)/(1+\sin\pi/N)$, formule dans laquelle N représente le nombre de tubes et r1 et r2 les rayons intérieur et extérieur respectivement de l'espace annulaire.

Des bobines solénoïdales sont alimentées par des alimentations électriques individualisées.

Avantageusement, les bobines solénoïdales sont formées de spires, de préférence à profil rectangulaire, hélicoïdales allongées le long de manchons circulaires conducteurs, plusieurs manchons d'une même bobine étant concentriques et engagés les uns dans les autres.

Dans ce cas, de préférence, un espace annulaire entre deux manchons est parcouru par un fluide de refroidissement.

Selon un mode de réalisation particulier, la part des gradients de champ produits dans des directions (x, y) perpendiculaires à l'axe z par les courants de Foucault induits dans l'écran cylindrique est déterminé par une technique de calculs électromagnétiques telle qu'une technique par éléments finis.

D'autres caractéristiques et avantages de l'invention ressortiront de la description suivante de modes particuliers de réalisation, donnés à titre d'exemples en référence aux dessins annexés sur lesquels :

- la Figure 1 est une vue schématique en coupe longitudinale d'une machine de RMN,
- la Figure 2 est une vue schématique en coupe perpendiculaire à l'axe du tunnel et du champ principal, montrant une machine de RMN à laquelle est applicable l'invention,
- la Figure 3 est une vue schématique en coupe perpendiculaire à l'axe du tunnel d'une machine de RMN selon l'invention,
- la Figure 4 est une vue schématique en coupe perpendiculaire à l'axe du tunnel, d'une partie de machine de RMN selon l'invention, adaptée pour dégager des espaces libres localisés,
- la Figure 5 est une vue schématique en perspective montrant un exemple d'application à un examen de "gradient de tête",
- la Figure 6A est une vue schématique montrant l'influence des courants de Foucault sur deux spires d'axe Oz en position de Maxwell selon l'art antérieur, et
- la Figure 6B est une vue schématique montrant l'influence des courants de Foucault sur un ensemble de spires d'axe parallèle à l'axe Oz mais à une certaine distance de celui-ci, conformément à l'invention.

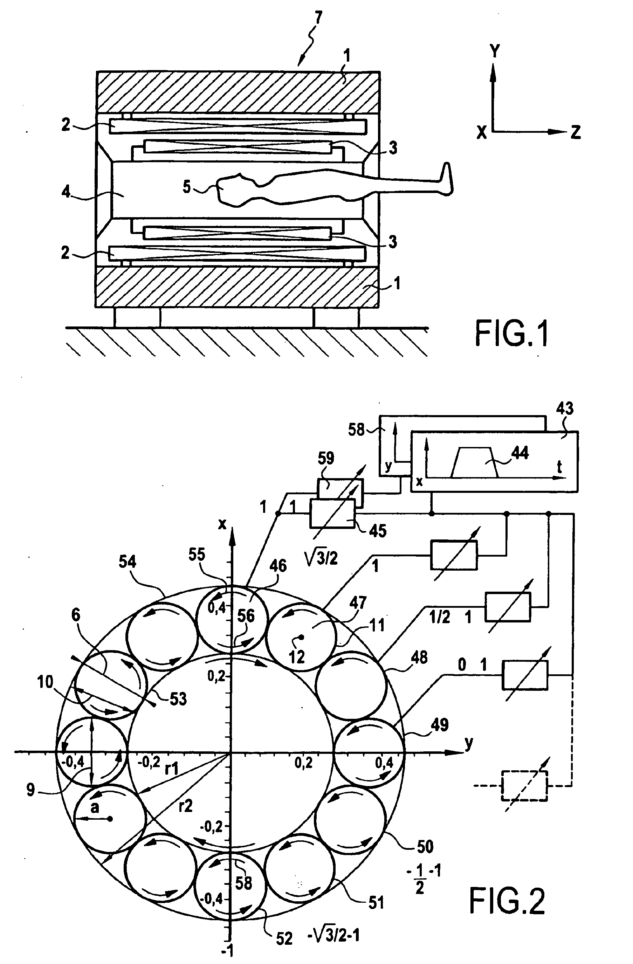

La Figure 1 représente de façon très schématique le principe d'une machine de RMN 7 avec un dispositif 1 de création d'un champ magnétique principal homogène et intense $B_0$ essentiellement parallèle à l'axe Z d'un tunnel 4 dans lequel est installé un patient 5.

Sur la Figure 1, le dispositif de création d'un champ magnétique principal intense $B_0$ peut comprendre des aimants permanents. Toutefois, ce dispositif peut également comprendre de façon privilégiée un aimant supraconducteur placé dans un cryostat destiné à maintenir cet aimant supraconducteur à très basse température. Dans tous les cas, le dispositif 1 de création d'un champ magnétique intense est placé dans une enceinte externe annulaire cylindrique qui ménage un espace annulaire entre la paroi interne de cette enceinte externe et le tunnel 4 dans lequel est placé le patient à examiner 5. L'enceinte externe annulaire cylindrique est généralement fermée par des parois métalliques par exemple en acier inoxydable.

Dans cet espace annulaire situé à l'intérieur du dispositif 1 de création d'un champ magnétique principal intense, sont disposées des bobines de gradient 2 destinées à créer des gradients de champ magnétique à la fois selon la direction de l'axe Z du tunnel 4 et selon les directions X et Y perpendiculaires entre elles et à l'axe Z.

Comme on l'a indiqué précédemment, les bobines de gradient 2 servent à créer un codage dans l'espace où se trouve le patient 5 par l'application de champs magnétiques supplémentaires pulsés.

Les composantes de ces champs magnétiques qui ne sont pas orientés comme le champ orientateur $B_0$ contribuent au deuxième ordre seulement (et donc de manière négligeable pour les valeurs considérées de $B_0$ et des gradients) à la modification du signal de RMN utile. Ainsi, la seule composante de ces champs magnétiques, produite par les bobines de gradient, qui est intéressante et utile est la composante orientée selon le champ $B_0$. Cette composante utile est appelée traditionnellement composante Bz ou $B_z$. La machine est repérée par rapport à un référentiel cartésien, l'axe z étant colinéaire à la direction du champ uniforme $B_0$ et parallèle aux génératrices de la machine tunnel. Selon les différents jeux de bobines de gradient alimentés, la composante Bz utile en un lieu verra son amplitude croître en fonction de l'abscisse x d'un plan contenant ce lieu, parallèle au plan yOz pour les gradients X, en fonction de l'ordonnée y d'un plan contenant ce lieu, parallèle au plan xOz pour les gradients Y, ou en fonction de la cote z d'un plan contenant ce lieu, parallèle au plan xOy pour les gradients Z.

Un dispositif 3 d'antennes d'émission radiofréquence est disposé au voisinage du tunnel 4 où se trouve le patient ou est inséré directement dans ce tunnel. Les bobines ou antennes d'émission radiofréquence sont associées de façon classique à des dispositifs de réception et de traitement des signaux radiofréquence émis en réponse par le corps du patient 5 ou tout autre objet étudié, tel qu'un animal par exemple.

Sur la figure 2, on a montré l'espace annulaire cylindrique 6 comme comportant des bobines solénoïdales circulaires dont le diamètre 9, de valeur 2a, est inscrit dans une épaisseur 10 de cet espace annulaire 6 délimité par des parois cylindriques 53, 54 présentant respectivement des rayons r1 et r2. On peut admettre dans un premier temps que l'épaisseur 10 de l'espace annulaire est égale à l'épaisseur totale de cet espace 6. Dans l'exemple représenté, l'espace annulaire 6 est ainsi occupé par douze tubes matérialisés par des enveloppes en matière plastique 11, ou en un autre matériau isolant électriquement. A l'intérieur des tubes 11, des bobines de production de champs magnétiques de gradient sont engagées, qui peuvent être réalisées comme décrit dans le document WO 2005/029110. De préférence les tubes sont contigus les uns aux autres.

Chaque tube peut être muni d'un jeu de bobines exactement identique à un jeu d'un autre tube. Ce jeu de bobine est avantageusement capable de produire un gradient Z et un gradient dans une direction choisie perpendiculaire à l'axe Z. Par la commande des différentes bobines, on peut destiner les différentes bobines à produire des gradients d'orientation X ou Y.

Dans l'exemple représenté, le nombre de tubes peut être pair, soit 2n, pour constituer les gradients de type X ou Y, ainsi que les gradients Z. Toutefois une réalisation particulière pourrait comprendre un nombre de premiers tubes pair pour contenir les bobines solénoïdales destinées à constituer des gradients de type X ou Y et un nombre impair de seconds tubes pour contenir les bobines destinées à constituer les gradients Z.

Ci-après sont exposées quelques notions de base utiles à la compréhension de l'invention.

On notera d'abord qu'un point M quelconque de l'espace peut être repéré par ses coordonnées cartésiennes (x,y,z) ou ses coordonnées sphériques (r, $\vartheta$, $\varphi$) avec :

$$\vec{r} = OM \quad r = |\vec{r}|$$

$$x = r \sin \vartheta \cos \varphi$$

$$y = r \sin \vartheta \sin \varphi$$

$$z = r\cos\vartheta$$

Le champ principal $\overrightarrow{B_0}$ est très sensiblement uniforme dans le volume d'intérêt autour de l'origine O et dirigé suivant l'axe

Oz :

$$\overrightarrow{B_0} = B_0 \vec{u}_z.$$

Dans une région de l'espace « magnétiquement » vide (c'est-à-dire sans courants électriques ou matériau de susceptibilité magnétique non négligeable), chaque composante $B_x$, $B_y$ et $B_z$ a son laplacien nul. Par exemple, quelles que soient les sources du champ, $\Delta B_z = 0$ et $B_z(\vec{r})$ a un développement unique en harmoniques sphériques de la forme :

$$B_z(r,\theta,\varphi) = Z_0 + \sum_{n=1}^{\infty} r^n \left[ Z_n P_n(\cos\theta) + \sum_{m=1}^{n} \left( X_n^m \cos m\varphi + Y_n^m \sin m\varphi \right) W_n^m P_n^m(\cos\theta) \right]$$

Où $W_n^m$ est un facteur numérique de pondération tel que $\left| W_n^m P_n^m(\cos\theta) \right| \leq 1$ comme $|P_n(\cos\theta)|$.

Ce développement n'est valable que pour $r < r_{max}$, rayon de la plus grande sphère « magnétiquement » vide de centre O. Les coefficients de degré n (on appelle m l'ordre) sont de la forme $\alpha\, r_{max}^{-n}$ où $\alpha$ a la dimension d'un champ et le développement converge d'autant plus rapidement que r est inférieur à $r_{max}$.

La réalisation d'images à partir de signaux de RMN nécessite un codage de l'espace. Ce codage est obtenu au moyen de sources de champ spécifiques dont la composante $b_z$ serait idéalement de la forme $b_z = g_x X$, $b_z = g_y Y$ et $b_z = g_z Z$ où $g_x$, $g_y$ et $g_z$ sont proportionnels aux courants d'excitation de leurs sources respectives. On les désignera en raccourci par gradient x, gradient y et gradient z respectivement.

En pratique, une telle linéarité ne peut être réalisée que de façon approchée avec des sources qui génèrent des champs $\vec{b}$ dont les composantes $b_x$ et $b_y$ ne sont pas nulles. Fort heureusement, ceci est sans importance dès lors que $|\vec{b}| \ll B_0$, ce qui est pratiquement toujours le cas. En effet, la fréquence de résonance est proportionnelle à :

$$\left| \vec{B} \right| = \sqrt{\left( B_0 + b_z \right)^2 + b_x^2 + b_y^2} = B_0 \sqrt{1 + 2\frac{b_z}{B_0} + \frac{b^2}{B_0^2}}$$

$$\simeq B_0 + b_z + \frac{b_x^2 + b_y^2}{2B_0} + \ldots = B_0 + b_z + B_0 \times O\left(\frac{b}{B_0}\right)^2$$

Ainsi, seule la composante $b_z$ intervient au niveau du ppm tant que $\dfrac{b}{B_0} \leq \sim 10^{-3}.$

Appliqué à la réalisation de gradients de champ magnétique, le principe de symétrie permet de démontrer que les propriétés de symétrie de la source de champ considérée conduisent à la nullité de certains des coefficients du développement en harmoniques sphériques susmentionné, quelles que soient les modalités de sa réalisation.

La génération des gradients de champ magnétique pour l'IRM a donné lieu à un nombre considérable de publications et de brevets et fait toujours l'objet d'une recherche intensive. Les modalités d'imagerie les plus modernes, notamment l'imagerie fonctionnelle, nécessitent des gradients les plus linéaires possible, toujours plus puissants et commutables très rapidement alors que le champ principal dans lequel ils doivent fonctionner est de plus en plus grand. Les puissances active et réactive nécessaires deviennent considérables avec les problèmes correspondants de refroidissement, d'isolement et de bruit acoustique.

Les problèmes posés par les courants induits dans les divers conducteurs situés au voisinage des générateurs de gradients deviennent également de plus en plus difficiles à résoudre.

Bien entendu, tous les systèmes connus utilisent les résultats de l'application du principe de symétrie. On peut cependant aller beaucoup plus loin dans l'annulation de certains des coefficients du développement en harmoniques sphériques en combinant plusieurs sources élémentaires alimentées par des courants liés par des relations de proportionnalité appropriées.

Considérons une distribution de courant antisymétrique par rapport au plan xOz et soit antisymétrique (AA), soit symétrique (AS), par rapport au plan xOy.

Une réalisation simple d'une telle distribution est par exemple constituée d'un ensemble de solénoïdes de même axe O'z' parallèle à Oz, à une distance d de celui-ci. Les coordonnées cartésiennes du centre O' de cet ensemble antisymétrique ou symétrique par rapport au plan xOy sont (d,0,0) avec l'une ou l'autre des deux configurations suivantes :

- l'ensemble (AA) comprend un nombre pair de solénoïdes situés de part et d'autre du plan xOy, les solénoïdes géométriquement symétriques étant parcourus par des courants tournant en sens opposés autour de l'axe O'z' (le cas le plus simple comporte donc deux solénoïdes antisymétriques) ;
- l'ensemble (AS) comprend un nombre quelconque de solénoïdes, les solénoïdes géométriquement symétriques par rapport au plan xOy étant parcourus par des courants tournant dans le même sens autour de l'axe O'Z' (le cas le plus simple comporte donc un seul solénoïde admettant xOy comme plan de symétrie).

Mais on peut envisager des configurations plus complexes, des bobinages sur des sections non circulaires et autour de plusieurs axes O'z' par exemple. Les seules conditions à respecter sont les propriétés de symétrie symbolisées par (AA) ou (AS).

Considérons l'un ou l'autre de ces ensembles parcouru par un courant d'intensité I et soit P la puissance dissipée correspondante.

En application directe du principe de symétrie, un ensemble (AA) produit dans la région d'intérêt un champ dont les termes non nuls du développement sont de la forme :

$$Z_{2p+1} \quad \forall p \geq 0$$

$$X_n^m \quad \forall m \geq 1, n = m + 2l + 1 \quad \forall l \geq 0$$

On démontre de la même façon qu'un ensemble (AS) parcouru par un courant d'intensité I produit dans la région d'intérêt un champ dont les termes non nuls du développement sont de la forme :

$$Z_{2p} \quad \forall p \geq 0$$

$$X_n^m \quad \forall m \geq 1, n = m + 2l \quad \forall l \geq 0$$

Les principes suivants peuvent être mis en oeuvre pour la réalisation d'un générateur de gradient Z.

Considérons N sources élémentaires identiques de type (AA) parcourues par le même courant I et régulièrement réparties autour de l'axe Oz. Les coordonnées des traces O'ⱼ de leurs axes sur le plan xOy sont donc :

$$\varphi_j = \varphi_0 + j\frac{2\pi}{N} \quad j \in [0, N-1]$$

où $\varphi_0$ est un azimut origine quelconque.

Le développement en harmoniques sphériques de la composante z du champ total produit est la somme des développements de type (AA) convenablement décalés en azimut $\varphi$, soit :

$$B_z(r,\theta,\varphi) = \sum_{p=0}^{\infty} r^{2p+1} N Z_{2p+1} P_{2p+1}(\cos\theta)$$

$$+ \sum_{m=1}^{\infty}\sum_{l=0}^{\infty} r^{m+2l+1} X_{m+2l+1}^m \left[\sum_{j=0}^{N-1}\cos m(\varphi-\varphi_j)\right] W_{m+2l+1}^m P_{m+2l+1}^m(\cos\theta)$$

Les sommes entre crochets se calculent comme suit :

$$\sum_{j=0}^{N-1}\cos m(\varphi-\varphi_j) = \sum_{j=0}^{N-1}\cos\left[m(\varphi-\varphi_0)-j\frac{2m\pi}{N}\right]$$

$$= \left[\sum_{j=0}^{N-1}\cos j\frac{2m\pi}{N}\right]\cos m(\varphi-\varphi_0) + \left[\sum_{j=0}^{N-1}\sin j\frac{2m\pi}{N}\right]\sin m(\varphi-\varphi_0)$$

$$= \left\{\begin{array}{l}0, m\neq kN \\ N\cos m(\varphi-\varphi_0), m=kN\end{array}\right\}\ \forall k\geq 1$$

Le développement du champ total se réduit donc à :

$$B_z(r,\theta,\varphi) = N\left[\begin{array}{l}\displaystyle\sum_{p=0}^{\infty} r^{2p+1} Z_{2p+1} P_{2p+1}(\cos\theta) \\[2mm] \displaystyle+ \sum_{k=1}^{\infty}\sum_{l=0}^{\infty} r^{kN+2l+1} X_{kN+2l+1}^{kN}\cos kN(\varphi-\varphi_0) W_{kN+2l+1}^{kN} P_{kN+2l+1}^{kN}(\cos\theta)\end{array}\right]$$

pour une puissance totale dissipée égale à NP.

Pratiquement, il suffira de choisir N assez grand, par exemple N = 12 ou plus, pour que les contributions des termes en $r^{kN+2l+1}$ $X_{kN+2l+1}^{kN}$ soient tout à fait négligeables et que le développement se réduise à :

$$B_z(r,\theta,\varphi) \approx N\sum_{p=0}^{\infty} r^{2p+1} Z_{2p+1} P_{2p+1}(\cos\theta)$$

$$= NZ_1 z + N\sum_{p=1}^{\infty} r^{2p+1} Z_{2p+1} P_{2p+1}(\cos\theta)$$

La linéarité du générateur du gradient z ainsi obtenu sera d'autant meilleure que l'on annulera plus de termes de degré 2p+1, p=1,2... du développement. Cette annulation ne dépend plus de considérations de symétrie mais de la distribution effective des courants dans la source élémentaire.

Dans une réalisation simple de la source élémentaire à base de solénoïdes coaxiaux, on peut, avec le minimum de deux solénoïdes géométriquement symétriques par rapport au plan xOy et parcourus par des courants opposés, choisir leurs dimensions et leurs positions pour annuler $Z_3$, le premier terme gouvernant les défauts de linéarité étant alors $Z_5$. Avec quatre solénoïdes de dimensions et positions convenablement choisies, on peut annuler $Z_3$ et $Z_5$, le premier terme gouvernant les défauts de linéarité devenant $Z_7$, etc.

Dans une recherche d'optimisation d'un tel générateur, on peut introduire d'autres considérations comme la minimisation de la puissance continue nécessaire pour obtenir un gradient permanent donné ou la minimisation de l'inductance pour permettre des temps de montée plus courts avec une tension maximum donnée ou encore une adaptation aux alimentations ou amplificateurs disponibles. Il est important de noter que ce principe de réalisation permet très facilement de recourir à plusieurs alimentations ou amplificateurs, réduisant ainsi leurs puissances unitaires.

La réalisation, suivant les mêmes principes, d'un générateur de gradient x (pour un générateur de gradient y le raisonnement est le même avec une rotation de $\dfrac{\pi}{2}$ autour de Oz) est également possible et se révèle tout aussi efficace pour obtenir la linéarité recherchée.

On doit utiliser un nombre pair N = 2n de sources élémentaires de type (AS) régulièrement réparties autour de l'axe Oz, le plan xOz étant un plan de symétrie de l'ensemble. Ce dernier élément de symétrie impose que l'azimut origine $\varphi_0$ soit O ou $\dfrac{\pi}{2n}$.

Les coordonnées des traces O'$_j$ de leurs axes sur le plan xOy sont donc soit

$$\varphi_j = j\frac{\pi}{n} \text{ , soit } \varphi_j = \frac{\pi}{2n} + j\frac{\pi}{n} \quad j \in [0, 2n-1].$$

On démontre alors que si les sources élémentaires sont alimentées par des courants d'intensité $I_j = I\cos\varphi_j$, le développement en harmoniques sphériques de la composante z du champ total produit se réduit à :

$$B_z(r,\theta,\varphi) = n\left[ \begin{array}{l} \displaystyle\sum_{p=0}^{\infty} r^{2p+1} X_{2p+1}^1 \cos\varphi\, W_{2p+1}^1 P_{2p+1}^1(\cos\theta) \\[2ex] + \begin{bmatrix} 1 \\ (-1)^k \end{bmatrix} \displaystyle\sum_{k=1}^{\infty}\sum_{l=0}^{\infty} r^{2kn-1+2l} X_{2kn-1+2l}^{2kn-1} \cos(2kn-1)\varphi\, W_{2kn-1+2l}^{2kn-1} P_{2kn-1+2l}^{2kn-1}(\cos\theta) \\[2ex] + \begin{bmatrix} 1 \\ (-1)^k \end{bmatrix} \displaystyle\sum_{k=1}^{\infty}\sum_{l=0}^{\infty} r^{2kn+1+2l} X_{2kn+1+2l}^{2kn+1} \cos(2kn+1)\varphi\, W_{2kn+1+2l}^{2kn+1} P_{2kn+1+2l}^{2kn+1}(\cos\theta) \end{array} \right]$$

pour une puissance totale dissipée égale à nP.

Le calcul est similaire à celui présenté précédemment avec les sommes suivantes à calculer :

$$\sum_{j=0}^{2n-1} \cos\varphi_j \cos m\varphi_j = \begin{cases} 0,\ m \neq 2kn \pm 1 \\ \begin{bmatrix} 1 \\ (-1)^k \end{bmatrix},\ m = 2kn \pm 1 \end{cases}$$

$$\sum_{j=0}^{2n-1} \cos\varphi_j \sin m\varphi_j = 0 \quad \forall m$$

le facteur $(-1)^k$ correspond au cas où l'azimut origine est $\dfrac{\pi}{2n}$.

Comme pour le gradient z, il suffit de choisir N = 2n (n étant un entier) assez grand pour que les contributions des termes en $r^{2kn\pm 1+2l}$ $\quad X^{2kn\pm 1}_{2kn\pm 1+2l}$ soient tout à fait négligeables et que le développement se réduise à :

$$B_z(r,\theta,\varphi) = n\sum_{p=0}^{\infty} r^{2p+1} X^1_{2p+1} \cos\varphi\, W^1_{2p+1} P^1_{2p+1}(\cos\theta)$$

$$= nX^1_1 x + n\sum_{p=1}^{\infty} r^{2p+1} X^1_{2p+1} \cos\varphi\, W^1_{2p+1} P^1_{2p+1}(\cos\theta)$$

La linéarité du générateur de gradient x ainsi obtenu sera d'autant meilleure que l'on annulera plus de termes de degré 2p+1, p = 1,2... du développement. Cette annulation ne dépend plus de considérations de symétrie mais de la distribution effective des courants dans la source élémentaire.

Dans une réalisation simple de la source élémentaire à base de solénoïdes coaxiaux avec le minimum d'un seul solénoïde, on ne peut annuler aucun des coefficients $X^1_{2p+1}$ $\forall p \geq 1$. Il faut au moins deux solénoïdes symétriques par rapport au plan xOy de dimensions et positions convenablement choisies pour annuler $X^1_3$, le premier terme gouvernant les défauts de linéarité étant alors $X^1_5$. Avec trois solénoïdes de dimensions et positions convenablement choisies, on peut annuler $X^1_3$ et $X^1_5$, le premier terme gouvernant les défauts de linéarité devenant $X^1_7$, etc.

Comme pour le générateur de gradient z, l'optimisation du système fera intervenir des considérations de puissance continue dissipée et d'inductance. Mais alors que pour le premier on pouvait avoir une seule alimentation avec toutes les sources élémentaires en série puisque l'intensité du courant était la même pour toutes, il faudra ici au moins autant d'alimentations que de valeurs de courants différentes (en valeur absolue).

Un autre aspect très important d'un tel dispositif est que ce sont les mêmes sources élémentaires qui peuvent servir à produire le gradient x et le gradient y, sans que l'on ait à mettre en place deux ensembles physiquement distincts comme dans les systèmes connus, notamment ceux décrits dans le document US 5 530 355.

Chaque source élémentaire sera ainsi alimentée par la somme algébrique des courants nécessaires à la production simultanée des deux valeurs de gradient souhaitées, suivant les formules explicitées supra. On notera toutefois que si les intensités et gradients s'ajoutent algébriquement, il n'en est pas de même des puissances dissipées qu'il importe de calculer pour chaque source élémentaire en fonction des séquences de gradients à produire.

Comme les valeurs des gradients x et y doivent être commandées séparément, on devra disposer in fine d'au moins n alimentations distinctes, soit une alimentation pour chaque paire de sources élémentaires antisymétriques par rapport à l'axe Oz.

Enfin, pour meilleure utilisation de l'espace limité disponible pour les générateurs de gradient, on peut adopter le même nombre de sources élémentaires pour les gradients x et y d'une part et pour le gradient z d'autre part, en réalisant une source élémentaire composite (AS) et (AA). Dans la réalisation simple d'une telle source élémentaire à base de solénoïdes coaxiaux, on peut par exemple combiner deux solénoïdes, symétriques par rapport au plan xOy, de dimensions et positions convenablement choisies pour annuler $X^1_3$ et quatre solénoïdes, antisymétriques deux à deux par rapport au plan xOy, de part et d'autre de chacun des deux solénoïdes précédents, avec des dimensions et positions convenablement choisies pour annuler $Z_3$ et $Z_5$.

Pour l'alimentation des bobines de gradient , la figure 2 montre que, pour un gradient X, un circuit électronique 43 produit une impulsion temporelle 44 ayant la forme (temps de montée, temps de descente) et la durée requise par une séquence d'imagerie à mettre en oeuvre avec la machine de RMN. Le signal 44 représentatif de l'impulsion est introduit dans un amplificateur 45 à gain variable et commandé.

La commande appliquée sur l'amplificateur 45, produite par un système informatique qui gère les séquences, provoque l'application d'un courant nominal multiplié par un coefficient qui vaut ici 1 pour les bobines situées dans un tube 46 situé dans le plan xOz.

Un tube 47 contigu au tube 46 dont l'axe, ici 12, est situé dans un plan passant par l'axe z et incliné de π/6 par rapport au plan xOz est alimenté par un courant multiplié par un coefficient valant √3/2. Pour un tube 48 contigu au tube 47 et encore décalé de ce dernier de π/6, le courant est multiplié par 1/2. Pour un tube 49 contigu au tube 48, et situé dans un plan yOz, le coefficient vaut 0. Pour un tube 50 symétrique du tube 48, le coefficient vaut -1/2, pour un tube 51 symétrique du tube 47, il vaut - √3/2, et pour un tube 52 symétrique du tube 46 par rapport à l'axe Z, le coefficient vaut -1. Pour les tubes situées à gauche de la figure et symétriques des tubes 46 à 52 par rapport au plan xOz, les valeurs de coefficient sont les mêmes (négatives en dessous de l'axe Y, positives au dessus de l'axe Y).

Le courant dans une bobine est ainsi proportionnel au cosinus de l'angle de repérage du tube qui la contient sur le pourtour de l'espace circulaire. Cette répartition des courants selon une variante peut également être décalée de 15°.

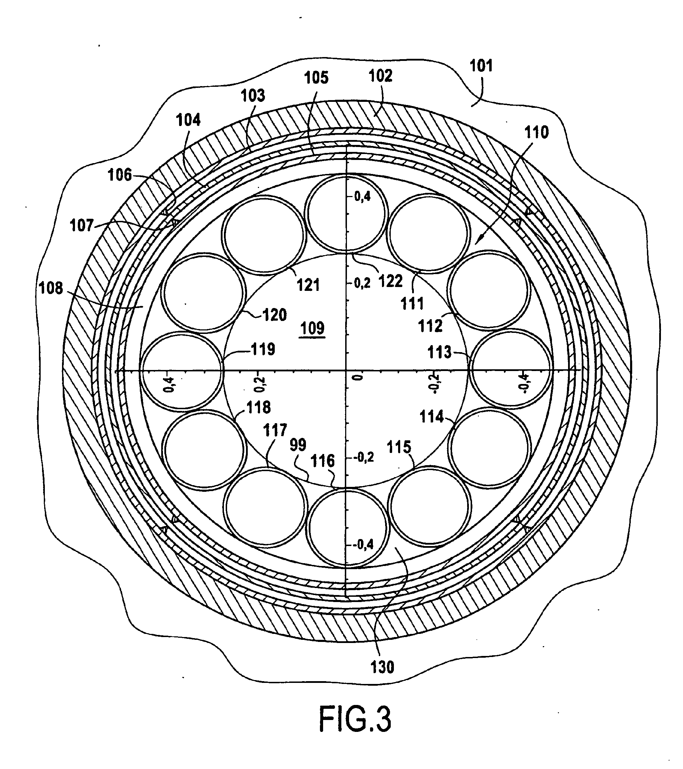

La figure 3 montre un mode particulier de réalisation de l'invention selon lequel, entre la paroi interne, par exemple en acier inoxydable, de l'enceinte cryogénique extérieure 102 incorporant le dispositif 101 de création de champ magnétique principal $B_0$ et la paroi 99 délimitant un espace intérieur utile 109 en forme de tunnel d'axe Z destiné à recevoir un patient, on trouve non seulement un espace annulaire cylindrique 130 destiné à recevoir un ensemble 110 de bobines de gradient solénoïdales 111 à 122 contenues dans des tubes d'axe parallèle à l'axe z, et pouvant être réalisées de la manière décrite précédemment, mais également un écran cylindrique 104 d'axe Z s'étendant sur une grande longueur le long de la machine et comprenant un matériau conducteur de faible résistance et de faible magnétorésistance.

De façon plus particulière, la conductivité électrique de l'écran cylindrique 104, sa longueur et son épaisseur sont choisies de telle manière que des courants induits négligeables soient générés dans l'enceinte cryogénique extérieure 102 tandis que les courants de Foucault induits dans l'écran cylindrique 104 lui-même apparaissent de façon contrôlée et exactement calculable et contribuent à renforcer les gradients produits par les bobines de gradient circulaires 111 à 122.

L'écran cylindrique 104 d'axe 0z, symétrique par rapport au plan xOy doit être suffisamment long, épais et bon conducteur pour que les champs électriques résiduels à l'extérieur ne génèrent que des courants induits tout à fait négligeables dans les enveloppes cryogéniques 102. La conductivité du matériau utilisé doit aussi être assez grande pour que la diffusion des courants induits dans l'écran soit négligeable pendant les temps caractéristiques de variation des gradients afin notamment que les courants établis par une montée de gradient disparaissent quasi exactement à sa descente.

Pratiquement ceci impose de choisir un écran en matériau supraconducteur ou encore en cuivre ou en aluminium refroidi au moins à la température de l'azote liquide (77 K) ou mieux, à plus basse température (20 à 40 K par exemple). L'aluminium se révèle alors un meilleur choix que le cuivre à cause de sa magnétorésistance plus faible. L'épaisseur minimum nécessaire pour cet écran est liée à l'épaisseur de peau correspondant aux temps caractéristiques de variation des gradients. En pratique, cette épaisseur de peau est suffisamment faible pour que les considérations de tenue mécanique soient déterminantes dans le choix de l'épaisseur de l'écran. A titre d'exemple, cette épaisseur peut être comprise entre 5 et 15 mm.

Selon un mode particulier de réalisation l'écran cylindrique 104 en matériau conducteur est disposé entre des premières et deuxièmes parois cylindriques 103, 105 en verre époxy. L'écran 104 est maintenu en position par rapport aux parois cylindriques 103, 105 à l'aide de supports isolants localisés 106, 107.

Il est important de noter que l'écran 104 ainsi introduit possède les propriétés de symétrie nécessaires pour que toutes les conclusions précédemment indiquées demeurent quant aux coefficients du développement en harmoniques sphériques nuls par raison de symétrie géométrique et aux relations entre intensités des courants des sources élémentaires. Pour un nombre suffisamment grand de ces sources, la linéarité des gradients ne dépendra donc encore que des coefficients $Z_{2p+1}$ pour le gradient z et X $\frac{1}{2p+1}$ pour les gradients x ou y (p≥1), coefficients qui doivent évidemment être calculés en tenant compte du champ généré par les courants de Foucault. Le calcul de ces derniers est simple pour le gradient z car on connaît a priori la géométrie des courants induits. Pour les gradients x ou y où ce n'est plus le cas, on fait appel à des techniques connues de calculs électromagnétiques (différences finies, éléments finis, méthodes spectrales, etc).

Dans une réalisation simple de source élémentaire à base de solénoïdes coaxiaux, tels que ceux décrits dans la présente demande ou dans le document de brevet WO 2005/029110, c'est-à-dire constitués par des bobines solénoïdales circulaires dont le diamètre est inscrit dans une épaisseur de l'espace annulaire cylindrique et dont l'axe est parallèle au champ principal, les courants induits dans l'écran 104 contribuent à renforcer les gradients produits et à augmenter de façon très significative l'efficacité du système. Au contraire, pour des réalisations classiques qui utiliseraient pour produire des gradients X ou Y à la place des bobines de gradient solénoïdales 111 à 122 placées dans des tubes, des bobines de gradient classiques telles que celles décrites par exemple dans le document de brevet FR 2 588 997, les courants qui seraient induits dans un écran tel que l'écran 104 tendraient à réduire les gradients produits.

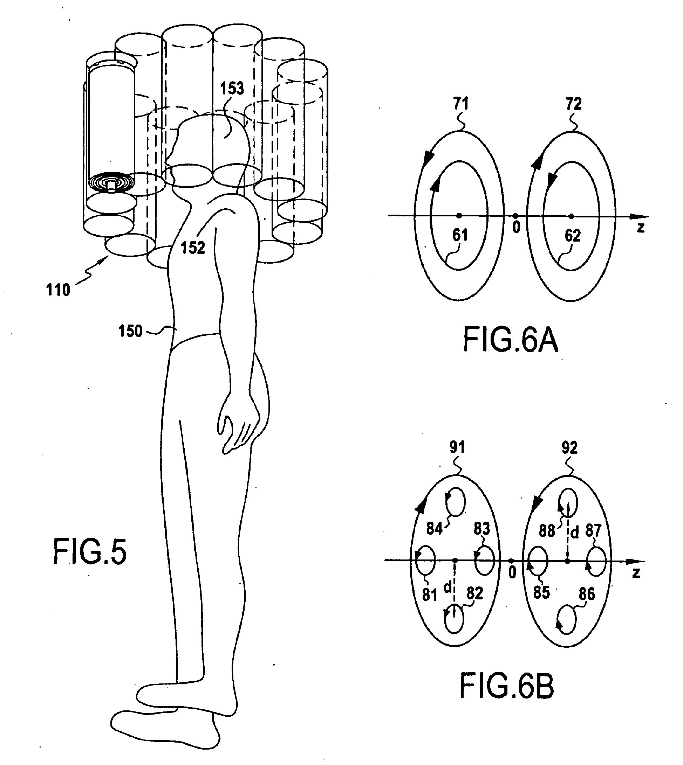

Pour illustrer cette comparaison, on considère un gradient Z et on a représenté sur la Figure 6A deux spires 61, 62 en position de Maxwell autour d'un axe Oz selon un mode de réalisation traditionnel, et sur la Figure 6B deux ensembles de spires 81 à 84 et 85 à 88 régulièrement réparties autour d'un axe Oz, mais en ayant chacune un axe parallèle à Oz et situé à une distance $\underline{d}$ de cet axe Oz, pour créer un gradient Z selon l'invention.

Sur la Figure 6A, les références 71, 72 désignent des lignes de champ de courant induit créées dans un écran conducteur classique disposé autour des spires de Maxwell 61, 62.

Sur la Figure 6B, les références 91, 92 désignent les lignes de champ de courant induit créées dans un écran conducteur disposé autour des spires 81 à 84 et 85 à 88 conformément à l'invention.

Sur les Figures 6A et 6B, les flèches indiquent le sens de circulation des courants dans les bobines de gradient et dans les lignes de champ de courant induit.

On voit que, contrairement au cas de l'art antérieur, les courants induits 91, 92 dans un écran d'un dispositif selon l'invention, tel que l'écran 104, tendent bien à renforcer les gradients produits par les spires de gradient 81 à 88, puisque ces lignes de courant induit 91, 92 se comportent alors comme des bobines de Maxwell supplémentaires.

De façon plus particulière, on voit sur la figure 6A deux spires 61, 62 d'axe Oz en position de Maxwell : la spire 62 située du côté z>0 est parcourue par un courant tournant dans le sens direct autour de Oz et croissant avec le temps, alors que la spire 61 située du côté z<0 est parcourue par un courant égal en valeur absolue mais de sens contraire.

Dans ces conditions, ces deux spires 61, 62 créent, au voisinage du centre O, un gradient $\dfrac{\partial \beta_z}{\partial z} > 0$ et croissant

dans le temps. Les cercles 71, 72 d'axe Oz et de diamètre plus grand que celui des spires de Maxwell 61, 62 représentent les lignes de champ des courants induits et la loi de Faraday $e = -\dfrac{d\phi}{dt}$ appliquée à chacun de ces circuits fermés 71, 72 prévoit, comme bien entendu la loi de Lenz, des courants de Foucault en sens inverse de ceux de la spire génératrice la plus voisine 61, 62, courants qui vont donc réduire le gradient que les deux spires de Maxwell 61, 62 auraient produit seules.

Sur la Figure 6B schématisant le système de la présente demande, les spires génératrices 81 à 88 sont des spires de diamètres inférieurs à celui des spires de Maxwell 61, 62 précédentes, leurs axes sont parallèles à Oz, mais à une certaine distance $\underline{d}$ de celui-ci, et elles sont régulièrement réparties comme expliqué plus haut. On n'a représenté que quatre spires 81 à 84 et 85 à 88 de chaque côté pour des raisons de clarté. Pour obtenir un gradient $\dfrac{\partial \beta_z}{\partial z} > 0$ comme précédemment, il faut maintenant que les courants générateurs tournent dans le sens inverse du côté z>0 et dans le sens direct du côté z<0. Quand ils croissent en valeur absolue, la loi de Lenz prévoit alors, dans les circuits fermés 91, 92 schématisant les courants de Foucault, un courant dans le sens direct du côté z>0 et dans le sens inverse du côté z<0, ces courants produisant bien une contribution positive au gradient, c'est-à-dire renforçant le gradient source.

Dans une machine conforme à l'invention, on met ainsi en oeuvre un écran passif qui, en combinaison avec des bobines de gradient solénoïdales décentrées par rapport à l'axe Oz, permet d'utiliser les courants de Foucault pour renforcer les gradients plutôt que pour les réduire.

L'écran conducteur est par ailleurs refroidi à une température suffisamment basse pour que les courants de Foucault ne s'atténuent pratiquement pas entre la montée et la descente de l'impulsion du gradient.

Enfin, la contribution des courants de Foucault au gradient total produit peut être calculée avec une grande précision, ce qui permet d'obtenir une excellente linéarité pour ce gradient.

Comme indiqué plus haut, pour que le système fonctionne correctement, il faut que la résistivité $\rho$ du matériau de l'écran cylindrique de rayon a, dans les conditions de son utilisation, soit suffisamment faible pour que l'on puisse négliger l'atténuation des courants de Foucault sur l'intervalle de temps $\Delta t$ pendant lequel on établit le gradient considéré au cours de la séquence d'imagerie (ces intervalles sont variables mais typiquement de l'ordre de quelques millisecondes avec des temps de montée et de descente de l'ordre de 100 microsecondes). On montre que l'on doit avoir

$\rho \ll \dfrac{\mu_0 a^2}{\Delta t}$, ce qui conduit à des résistivités de l'ordre de $10^{-9}$ $\Omega.m$. A température ambiante, la résistivité de l'aluminium est plus grande que celle du cuivre sensiblement égale à 100% IACS ($1{,}7241 \times 10^{-8}$ $\Omega.m$) mais elle décroît plus vite avec la température et, à 50 K, les résistivités du cuivre et de l'aluminium sont les mêmes, soit $0{,}5 \times 10^{-9}$ $\Omega.m$ qui correspond bien à la valeur recherchée. Cependant, l'écran est soumis au champ principal $B_0$ qui atteint plusieurs teslas dans les machines à haut champ et la résistivité des métaux augmente avec le champ. Ce phénomène, la magnétorésistance, est plus important pour le cuivre dont la résistivité augmente quasi linéairement avec le champ (d'où son utilisation comme magnétomètre) alors que, pour l'aluminium, il y a "saturation" du phénomène dans cette gramme de champ, d'où l'intérêt de ce dernier pour l'application proposée.

Un écran en matériau supraconducteur ($\rho\equiv 0$) constitue également une solution idéale lorsqu'il est conçu pour supporter le champ principal élevé, ainsi que les variations rapides du champ des gradients.

Comme on l'a déjà indiqué, l'invention peut s'appliquer à des machines de RMN dans lesquelles les bobines de gradients 111 à 122 sont telles qu'une bobine solénoïdale circulaire dont le diamètre est inscrit dans l'espace annulaire cylindrique 130 et qui produit un gradient de champ z dans une première direction z est coaxiale avec une autre bobine solénoïdale inscrite dans un même tube de cet espace annulaire cylindrique 130 et produisant un gradient de champ X dans une direction inclinée x par rapport à la direction z.

L'invention peut toutefois s'appliquer de la même manière à des machines de RMN dans lesquelles seules les bobines de gradient 111 à 122 de type solénoïdal produisant des gradients de champ X, Y dans des directions perpendiculaires à la direction z sont disposées dans des tubes dans l'épaisseur de l'espace annulaire cylindrique 130 tandis que pour la production du gradient de champ z on recourt à une solution plus classique dans laquelle des bobines annulaires de production d'un gradient de champ magnétique orienté selon une génératrice de la machine sont disposées sur une paroi externe 108 de cet espace annulaire 130 et non à l'intérieur de cet espace. Les solutions classiques présentent en effet moins d'inconvénients pour la création du gradient de champ Z que pour la création des gradients de champ X, Y.

L'efficacité des générateurs de gradient en régime permanent $\dfrac{G}{\sqrt{P}}$ (où G est le gradient de champ produit pour une puissance dissipée P) est d'autant meilleure que les courants sources sont proches du volume d'intérêt. L inductance est également réduite si les dimensions du générateur sont plus faibles. C'est pour cette raison que l'on réalise des systèmes spécifiques pour l'imagerie du cerveau appelés « gradients tête » de dimensions bien inférieures à celle des gradients dits « corps entier ». La Figure 5 montre schématiquement un exemple avec un patient 150 dont seule la tête 153 est insérée à l'intérieur du volume d'intérêt sur lequel agit l'ensemble 110 des bobines de gradient. Certaines contradictions entre les contraintes géométriques résultant des équations de Maxwell d'une part et de la morphologie du corps humain d'autre part pourraient être levées si de la place était libérée pour le passage des épaules 151, 152 du sujet à examiner. On supposera que celui-ci est installé de façon telle qu'il est allongé suivant l'axe Oz et que l' « axe » de ses épaules est dans le plan xOz et parallèle à Ox.

Afin de ménager un passage libre pour les épaules 151, 152, on considère une configuration de générateurs de gradients à N=2n sources élémentaires d'azimut origine $\varphi_0 = 0$ dans laquelle on supprime les deux sources élémentaires correspondant à $\varphi_j = 0$ et $\varphi_j = \pi$. Il est alors encore possible de trouver des combinaisons de courants d'alimentation des sources élémentaires qui conduisent à la meilleure linéarité possible, avec une réduction de l'efficacité qui reste acceptable.

Dans le cas du générateur de gradient z constitué par des bobines solénoïdales circulaires placées dans l'espace annulaire 130, on part simplement d'une configuration à N = 2n sources élémentaires avec $\varphi_0 = 0$ et on supprime une source sur deux.

Si le nombre entier n est suffisamment grand, la linéarité sera toujours gouvernée par la structure de la source élémentaire. L'efficacité $\dfrac{G}{\sqrt{P}}$ est seulement divisée par $\sqrt{2}$.

Ce faisant, on a non seulement ménagé un passage pour les épaules 151, 152 du patient mais aussi suivant d'autres directions, celles qui correspondent aux autres sources supprimées, ce qui peut présenter un intérêt en termes d'accessibilité ou de logement d'accessoires.

En ce qui concerne le générateur de gradient x et y constitué par des bobines solénoïdales circulaires placées dans l'espace annulaire 130, on doit distinguer deux cas suivant que n est pair ou impair.

n pair

Si n = 2υ, la solution est la même que pour le gradient z. Si υ est suffisamment grand, la linéarité sera toujours gouvernée par la structure de la source élémentaire et l'efficacité $\dfrac{G}{\sqrt{P}}$ est simplement divisée par $\sqrt{2}$.

n impair

le cas n = 2υ+1 implique de supprimer effectivement que les deux sources élémentaires correspondant au passage des épaules et de nouvelles relations doivent être établies entre les courants des sources restantes. On remarquera cependant que pour le gradient y, rien n'est changé par rapport au cas sans suppression de source puisque les deux sources élémentaires supprimées n'étaient alors pas alimentées. La linéarité et l'efficacité de ce gradient y sont donc conservées.

Pour le gradient x on doit prendre en compte les aspects suivants : les coordonnées des traces O'$_j$ des axes des sources élémentaires sur le plan xOy sont maintenant $\varphi_j = j\dfrac{\pi}{2\upsilon+1}$ $j \in [1,2\upsilon] \cup [2\upsilon+2, 4\upsilon+1]$ et la meilleure linéarité possible est obtenue avec des courants d'intensités :

$$I_j = I\left[\cos\varphi_j - (-1)^j\right]$$

Les calculs se déroulent en remplaçant cos$\varphi_j$ par cos$\varphi_j$-(-1)$^j$ dans les sommes à calculer et en remarquant que la sommation sur j peut être étendue, de 0 à 2n-1=4$\upsilon$+1 puisque j=0 et j=2$\upsilon$+1 correspondant aux sources élémentaires supprimées donnent cos$\varphi_j$-(-1)$^j$=0.

On trouve alors :

$$B_z(r,\theta,\varphi) = n\left[\begin{array}{l} \sum_{p=0}^{\infty} r^{2p+1} X_{2p+1}^{1} \cos\varphi\, W_{2p+1}^{1} P_{2p-1}^{1}(\cos\theta) \\[2mm] -2\sum_{k=1}^{\infty}\sum_{l=0}^{\infty} r^{(2k-1)n+2l} X_{(2k-1)n+2l}^{(2k-1)n} \cos(2k-1)n\varphi\, W_{(2k-1)n+2l}^{(2k-1)n} P_{(2k-1)n+2l}^{(2k-1)n}(\cos\theta) \\[2mm] +\sum_{k=1}^{\infty}\sum_{l=0}^{\infty} r^{2kn-1+2l} X_{2kn-1+2l}^{2kn-1} \cos(2kn-1)\varphi\, W_{2kn-1+2l}^{2kn-1} P_{2kn-1+2l}^{2kn-1}(\cos\theta) \\[2mm] +\sum_{k=1}^{\infty}\sum_{l=0}^{\infty} r^{2kn+1+2l} X_{2kn+1+2l}^{2kn+1} \cos(2kn+1)\varphi\, W_{2kn+1+2l}^{2kn+1} P_{2kn+1+2l}^{2kn+1}(\cos\theta) \end{array}\right]$$

avec une puissance dissipée égale à 3nP.

La linéarité est donc moins bonne que celle du gradient y avec de nouveaux termes non nuls en $X_{(2k-1)n+2l}^{(2k-1)n}$, notamment celui de degré le plus bas $X_n^n$, mais il suffira de choisir n assez grand pour garantir la qualité recherchée.

L'efficacité en régime permanent est simplement divisée par $\sqrt{3}$.

Pour aménager l'accessibilité au niveau des épaules 151, 152 d'un patient, on a donc le choix entre deux configurations possibles.

On peut dimensionner les sources élémentaires comme si l'on devait en disposer un nombre multiple de 4, N=4$\upsilon$, et n'en installer effectivement qu'une sur deux , soit 2$\upsilon$. Cette solution est valable pour les gradients dans les trois directions et réduit pour chacun l'efficacité d'un facteur $\sqrt{2}$ par rapport à la situation où l'on aurait installé les N=4$\upsilon$ sources. Elle permet également d'utiliser des sources élémentaires combinées pour les axes x y et z.

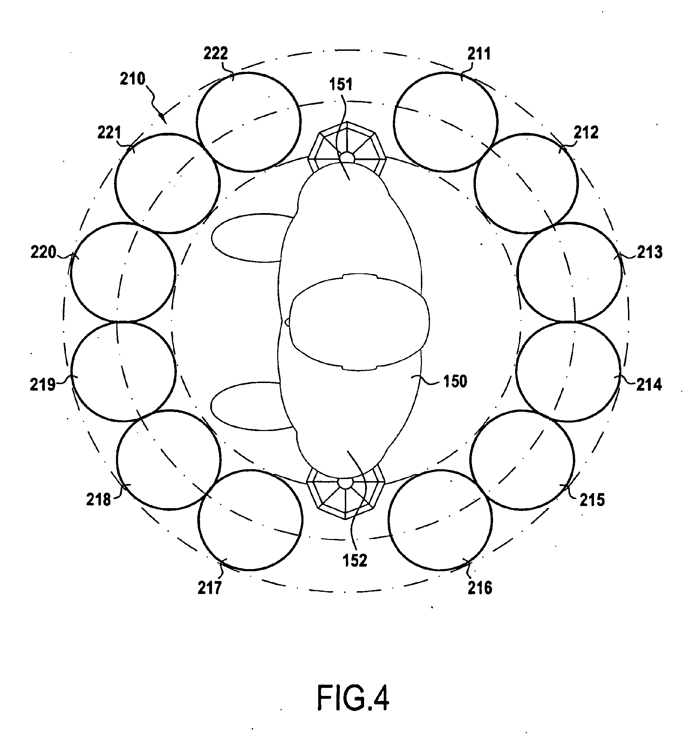

On peut également dimensionner les sources élémentaires comme si l'on devait en disposer un nombre N=4$\upsilon$+2 et n'en installer effectivement que 4$\upsilon$ (références 211 à 222 de la Figure 4) en supprimant les deux sources élémentaires correspondant au passage des épaules 151, 152 dans le plan xOz. Le gradient y est alors identique à celui que l'on aurait obtenu avec toutes les sources alors que le gradient x a son efficacité réduite d'un facteur $\sqrt{3}$. Il n'y a pas de solution de ce type pour le gradient z qui doit, dans ces conditions, être installé dans un espace extérieur à celui occupé par l'ensemble 210 des sources précédents et ne nécessite donc plus d'aménagement particulier pour le passage des épaules.

Sur la Figure 4, par mesure de clarté on n'a pas représenté l'écran cylindrique 106 ni les éléments associés, mais ceux-ci peuvent être réalisés de la même manière qu'illustré sur la Figure 3.

**EP 1 952 171 B1**

**Revendications**

1. Machine de résonance magnétique nucléaire, comprenant des moyens (101) de création d'un champ magnétique principal intense $B_0$ dans un espace intérieur utile (109) en forme de tunnel d'axe Z, des moyens d'excitation radiofréquence et de traitement des signaux radiofréquence émis en réponse par un corps (150) ou objet disposé dans ledit espace intérieur utile (109), et un ensemble (110, 210) de bobines de gradient solénoïdales pour superposer au champ magnétique intense $B_0$ des composantes d'un champ magnétique supplémentaire, lesdites bobines de gradient (111-122 ; 211-222) étant incorporées dans des tubes disposés dans un espace annulaire cylindrique (130) situé entre une enceinte cryogénique extérieure (102) contenant lesdits moyens (101) de création d'un champ magnétique intense $B_0$ et ledit espace intérieur utile (109), le diamètre des bobines de gradient (111-122 ; 211-222) étant inscrit dans une épaisseur dudit espace annulaire cylindrique (130), les bobines de gradient (111-122 ; 211-222) présentant des axes parallèles au champ magnétique principal $B_0$, les bobines de gradient solénoïdales (111-122 ; 211-222) étant adaptées pour produire à la fois un premier gradient de champ X dans une première direction x radiale de la machine perpendiculaire à l'axe Z, et un deuxième gradient de champ Y dans une deuxième direction y radiale de la machine également perpendiculaire à l'axe Z, la première direction x étant perpendiculaire à la deuxième direction y, et la machine comportant des amplificateurs (45, 59) pour alimenter simultanément ces bobines solénoïdales par des sommes algébriques de courants correspondant aux deux gradients, une bobine solénoïdale dont le diamètre est inscrit dans l'espace annulaire cylindrique (130) et qui produit un gradient de champ Z dans une direction z parallèle au champ principal $B_0$ étant coaxiale avec une autre bobine solénoïdale inscrite dans un même tube de cet espace annulaire cylindrique (130) et produisant un gradient de champ X dans ladite première direction x perpendiculaire à la direction z, **caractérisée en ce qu'**elle comprend en outre entre ladite enceinte cryogénique extérieure (102) et ledit espace annulaire cylindrique (130) un écran cylindrique (104) long d'axe Z comprenant un matériau conducteur refroidi à une température inférieure ou égale à 77 K et choisi de manière à présenter une résistivité inférieure ou égale à $10^{-8}$ $\Omega$.m tel que des courants induits négligeables sont générés dans l'enceinte cryogénique extérieure (102) tandis que les courants de Foucault induits dans l'écran cylindrique (104) contribuent à renforcer les gradients produits par lesdites bobines de gradient solénoïdales (111-122 ; 211-222).

2. Machine selon la revendication 1, **caractérisée en ce que** l'écran cylindrique (104) est en aluminium.

3. Machine selon la revendication 1, **caractérisée en ce que** l'écran cylindrique (104) est en cuivre.

4. Machine selon la revendication 1, **caractérisée en ce que** l'écran cylindrique (104) est en matériau supraconducteur.

5. Machine selon l'une quelconque des revendications 1 à 4, **caractérisée en ce que** l'écran cylindrique (104) est adapté pour être refroidi à une température comprise entre 20 et 40 K.

6. Machine selon l'une quelconque des revendications 1 à 5, **caractérisée en ce que** l'écran cylindrique (104) en matériau conducteur est disposé entre des première et deuxième parois cylindriques (103, 105) en verre époxy, l'écran cylindrique (104) étant maintenu en position par rapport aux première et deuxième parois cylindriques (103, 105) à l'aide de supports isolants localisés (106, 107).

7. Machine selon l'une quelconque des revendications 1 à 6, **caractérisée en ce que** l'écran cylindrique (104) présente une épaisseur comprise entre 5 et 15 mm.

8. Machine selon l'une quelconque des revendications 1 à 7, **caractérisée en ce que** les bobines de gradient solénoïdales (111, 113, 115, 117, 119, 121) incorporées dans des tubes constituent des sources élémentaires de gradients de champ X, Y et Z qui sont dimensionnées comme faisant partie d'un ensemble de N sources élémentaires contiguës réparties selon le pourtour de l'espace annulaire cylindrique, où $N = 4\upsilon$, $\upsilon$ étant un entier supérieur ou égal à 2, mais où une source élémentaire sur deux est omise pour ne conserver que $2\upsilon$ sources élémentaires non contiguës, chaque tube étant muni d'une source élémentaire.

9. Machine selon l'une quelconque des revendications 1 à 7, **caractérisée en ce que** les bobines solénoïdales (111-122 ; 211-222) sont réparties selon le pourtour de l'espace annulaire (130) en 2n arrangements de bobines solénoïdales coaxiales où n est un entier supérieur ou égal à 3.

10. Machine selon l'une quelconque des revendications 1 à 7, **caractérisée en ce que** les bobines solénpoïdales (111-122 : 211-222) sont réparties selon le pourtour de l'espace annulaire (130) en 2n arrangements de bobines solénoïdales coaxiales, et **en ce que** la machine est adaptée pour alimenter plusieurs bobines simultanément par des combinaisons de courants pour produire un gradient X et/ou Y et/ou Z, n étant un entier supérieur ou égal à 3.

11. Machine selon la revendication 10, arrangée de telle sorte qu'une composante d'un courant qui passe dans une bobine pour produire un gradient soit proportionnelle à un courant nominal multiplié par un cosinus d'un angle de repérage de la bobine sur le pourtour de l'espace annulaire.

12. Machine selon l'une quelconque des revendications 1 à 7, **caractérisée en ce que** l'espace annulaire (130) comporte plusieurs tubes contigus répartis sur le pourtour pour recevoir les bobines solénoïdales, le rayon a d'un tube étant donné par a = r1(sin$\pi$/N)/(1-sin$\pi$/N) = r2(sin$\pi$/N)/(1+sin$\pi$/N), formule dans laquelle N représente le nombre de tubes et r1 et r2 les rayons intérieur et extérieur respectivement de l'espace annulaire (130).

13. Machine selon l'une quelconque des revendications 1 à 12, arrangée de telle sorte que des bobines solénoïdales soient alimentées par des alimentations électriques individualisées.

14. Machine selon l'une quelconque des revendications 1 à 13, **caractérisée en ce que** les bobines solénoïdales sont formées de spires, de préférence à profil rectangulaire, hélicoïdales allongées le long de manchons circulaires conducteurs, plusieurs manchons d'une même bobine étant concentriques et engagés les uns dans les autres.

15. Machine selon la revendication 14, arrangée de telle sorte qu'un espace annulaire entre deux manchons soit parcouru par un fluide de refroidissement.

**Claims**

1. A nuclear magnetic resonance machine comprising means (101) for creating an intense main magnetic field $B_0$ in a usable interior space (109) in the form of a tunnel with axis Z, means for radio-frequency excitation and for processing radio-frequency signals emitted in response by a body (150) or object placed in said usable interior space (109), and a set (110, 210) of solenoidal gradient coils for superimposing on the intense magnetic field $B_0$ components of an additional magnetic field, said gradient coils (111-122; 211-222) being incorporated into tubes disposed in an annular cylindrical space (130) situated between an exterior cryogenic enclosure (102) containing said means (101) for creating an intense magnetic field $B_0$ and said usable interior space (109), the diameter of the gradient coils (111-122; 211-222) being inscribed in a thickness of said annular cylindrical space (130), the gradient coils (111-122; 211-222) having axes which are parallel to the main magnetic field $B_0$, the solenoidal gradient coils (111-122; 211-222) being adapted to produce both a first field gradient X in a first radial direction x of the machine perpendicular to the axis Z and a second field gradient Y in a second radial direction y of the machine also perpendicular to the axis Z, the first direction x being perpendicular to the second direction y, and the machine including amplifiers (45, 59) for simultaneously energizing said solenoidal coils with algebraic sums of currents corresponding to the two gradients, a solenoidal coil whose diameter is inscribed in the cylindrical annular space (130) and that produces a field gradient Z in a direction (z) parallel to the main field $B_0$ being coaxial with another solenoidal coil inscribed in the same tube of this annular cylindrical space (130) and producing a field gradient X in said first direction x perpendicular to the direction z, **characterized in that** it further comprises between said exterior cryogenic enclosure (102) and said annular cylindrical space (130) an elongate cylindrical screen (104) along the axis Z comprising a conductive material cooled to a temperature less than or equal to 77 K and chosen to have resistivity less than or equal to $10^{-8}$ $\Omega$.m such that negligible induced currents are generated in the exterior cryogenic enclosure (102) while the eddy currents induced in the cylindrical screen (104) contribute to reinforcing the gradients produced by said solenoidal gradient coils (111-122; 211-222).

2. A machine according to claim 1, **characterized in that** the cylindrical screen (104) is made of aluminum.

3. A machine according to claim 1, **characterized in that** the cylindrical screen (104) is made of copper.

4. A machine according to claim 1, **characterized in that** the cylindrical screen (104) is made of a superconductor material.

5. A machine according to any one of claims 1 to 4, **characterized in that** the cylindrical screen (104) is adapted to be cooled to a temperature in the range 20 K to 40 K.

**6.** A machine according to any one of claims 1 to 5, **characterized in that** the cylindrical screen (104) of conductive material is disposed between first and second cylindrical glassfiber-reinforced epoxy walls (103, 105), the cylindrical screen (104) being held in position relative to the first and second cylindrical walls (103, 105) with the aid of localized insulative supports (106, 107).

**7.** A machine according to any one of claims 1 to 6, **characterized in that** the cylindrical screen (104) has a thickness in the range 5 mm and 15 mm.

**8.** A machine according to any one of claims 1 to 7, **characterized in that** the solenoidal gradient coils (111, 113, 115, 117, 119, 121) incorporated in tubes constitute individual sources of X, Y and Z field gradients that are dimensioned as forming part of a set of N contiguous individual sources distributed at the perimeter of the cylindrical annular space, where $N = 4\upsilon$, $\upsilon$ being an integer greater than or equal to 2, but where one in two individual sources is omitted so as to retain only $2\upsilon$ non-contiguous individual sources, each tube being provided with one individual source.

**9.** A machine according to any one of claims 1 to 7, **characterized in that** the solenoidal coils (111-122; 211-222) are distributed at the perimeter of the annular space (130) in 2n arrangements of coaxial solenoidal coils where $\underline{n}$ is an integer greater than or equal to 3.

**10.** A machine according to any one of claims 1 to 7, **characterized in that** the solenoidal coils (111-122 ; 211-222) are distributed at the perimeter of the annular space (130) in 2n arrangements of coaxial solenoidal coils, and **in that** the machine is adapted to energize a plurality of coils simultaneously by combinations of currents to produce a X and/or Y and/or Z gradient, $\underline{n}$ being an integer greater than or equal to 3.

**11.** A machine according to claim 10, arranged in such a manner that a component of a current that flows in a coil to produce a gradient is proportional to a nominal current multiplied by the cosine of an angle that identifies the coil on the perimeter of the annular space.

**12.** A machine according to any one of claims 1 to 7, **characterized in that** the annular space (130) includes contiguous tubes distributed at the perimeter to receive the solenoidal coils, the radius $\underline{a}$ of a tube being given by $a = r1(\sin\pi/N)/(1-\sin\pi/N) = r2(\sin\pi/N)/(1+\sin\pi/N)$, in which formula N represents the number of tubes and r1 and r2 the inside and outside radii, respectively, of the annular space (130).

**13.** A machine according to any one of claims 1 to 12, arranged in such a manner that the solenoidal coils are energized by individual electrical power supplies.

**14.** A machine according to any one of claims 1 to 13, **characterized in that** the solenoidal coils are formed of elongate helicoidal turns, preferably of rectangular profile, along circular conductive sleeves, several sleeves of the same coil being concentric and engaged one within another.

**15.** A machine according to claim 14, arranged in such a manner that a cooling fluid flows in an annular space between two sleeves.


**Patentansprüche**

**1.** Kernspinresonanzmaschine, umfassend Mittel (101) zum Erzeugen eines starken magnetischen Hauptfeldes $B_0$ in einem tunnelförmigen Nutzinnenraum (109) mit der Achse Z, Mittel zur Radiofrequenzerregung und zur Verarbeitung der durch einen Körper (150) oder ein Objekt, der/das in dem Nutzinnenraum (109) angeordnet ist, als Reaktion ausgesandten Radiofrequenzsignale, sowie eine Anordnung (110, 210) von Solenoid-Gradientenspulen, um dem starken Magnetfeld $B_0$ Komponenten eines zusätzlichen Magnetfeldes zu überlagern, wobei die Gradientenspulen (111-122; 211-222) in Röhren eingesetzt sind, die in einem zylindrischen Ringraum (130) angeordnet sind, welcher zwischen einem die Mittel (101) zum Erzeugen eines starken Magnetfeldes $B_0$ enthaltenden kryogenen Außenraum (102) und dem Nutzinnenraum (109) gelegen ist, wobei der Durchmesser der Gradientenspulen (111-122; 211-222) innerhalb einer Dicke des zylindrischen Ringraums (130) liegt, wobei die Gradientenspulen (111-122; 211-222) zu dem magnetischen Hauptfeld $B_0$ parallel verlaufende Achsen aufweisen, wobei die Solenoid-Gradientenspulen (111-122; 211-222) dazu ausgelegt sind, sowohl einen ersten Feldgradienten X in einer ersten radialen Richtung x der Maschine, welche zu der Z-Achse senkrecht verläuft, als auch einen zweiten Feldgradienten Y in einer zweiten radialen Richtung y der Maschine, welche ebenfalls zu der Z-Achse senkrecht verläuft, zu erzeugen, wobei die erste Richtung x zu der zweiten Richtung y senkrecht verläuft, und wobei die Maschine Verstärker (45, 59) umfaßt, um diese Solenoidspulen gleichzeitig mit algebraischen Summen von Strömen, die den beiden Gradienten entsprechen, zu versorgen, wobei eine Solenoidspule, deren Durchmesser innerhalb des zylindrischen Ringraums (130) liegt und die einen Feldgradienten Z in einer zu dem Hauptfeld $B_0$ parallelen Richtung z erzeugt, zu einer weiteren Solenoidspule, die innerhalb einer gleichen Röhre dieses zylindrischen Ringraums (130) liegt und einen Feldgradienten X in der zu der Richtung z senkrecht verlaufenden ersten Richtung x erzeugt, koaxial ist, **dadurch gekennzeichnet, daß** sie ferner zwischen dem kryogenen Außenraum (102) und dem zylindrischen Ringraum (130) einen langen zylindrischen Schirm (104) mit der Achse Z umfaßt, der ein leitendes Material aufweist, das auf eine Temperatur von unter oder gleich 77 K gekühlt und ausgewählt ist, um einen spezifischen Widerstand kleiner oder gleich $10^{-8}\,\Omega.m$ aufzuweisen, derart, daß vernachlässigbare induzierte Ströme in dem kryogenen Außenraum (102) erzeugt werden, während die in dem zylindrischen Schirm (104) induzierten Wirbelströme dazu beitragen, die durch die Solenoid-Gradientenspulen (111-122; 211-222) erzeugten Gradienten zu verstärken.

2.  Maschine nach Anspruch 1, **dadurch gekennzeichnet, daß** der zylindrische Schirm (104) aus Aluminium besteht.

3.  Maschine nach Anspruch 1, **dadurch gekennzeichnet, daß** der zylindrische Schirm (104) aus Kupfer besteht.

4.  Maschine nach Anspruch 1, **dadurch gekennzeichnet, daß** der zylindrische Schirm (104) aus supraleitendem Material besteht.

5.  Maschine nach einem der Ansprüche 1 bis 4, **dadurch gekennzeichnet, daß** der zylindrische Schirm (104) dazu ausgelegt ist, auf eine Temperatur im Bereich zwischen 20 und 40 K gekühlt zu werden.

6.  Maschine nach einem der Ansprüche 1 bis 5, **dadurch gekennzeichnet, daß** der zylindrische Schirm (104) aus leitendem Material zwischen einer ersten und einer zweiten zylindrischen Wand (103, 105) aus Epoxidglas angeordnet ist, wobei der zylindrische Schirm (104) gegenüber der ersten und der zweiten zylindrischen Wand (103, 105) mit Hilfe von stellenweisen isolierenden Haltern (106, 107) in Position gehalten wird.

7.  Maschine nach einem der Ansprüche 1 bis 6, **dadurch gekennzeichnet, daß** der zylindrische Schirm (104) eine Dicke im Bereich zwischen 5 und 15 mm aufweist.

8.  Maschine nach einem der Ansprüche 1 bis 7, **dadurch gekennzeichnet, daß** die in Röhren eingesetzten Solenoid-Gradientenspulen (111, 113, 115, 117, 119, 121) Einzelquellen von Feldgradienten X, Y und Z bilden, die als zu einer Anordnung von benachbarten, entlang dem Umfang des zylindrischen Ringraums verteilten N Einzelquellen gehörend ausgelegt sind, wobei N = 4u, wobei u eine ganze Zahl größer oder gleich 2 ist, wobei aber jede zweite Einzelquelle weggelassen ist, um nur 2u nicht benachbarte Einzelquellen zu behalten, wobei jede Röhre mit einer Einzelquelle versehen ist.

9.  Maschine nach einem der Ansprüche 1 bis 7, **dadurch gekennzeichnet, daß** die Solenoidspulen (111-122; 211-222) entlang dem Umfang des Ringraums (130) in 2n Anordnungen von koaxialen Solenoidspulen, wobei n eine ganze Zahl größer oder gleich 3 ist, aufgeteilt sind.

10. Maschine nach einem der Ansprüche 1 bis 7, **dadurch gekennzeichnet, daß** die Solenoidspulen (111-122; 211-222) entlang dem Umfang des Ringraums (130) in 2n Anordnungen von koaxialen Solenoidspulen aufgeteilt sind und daß die Maschine dazu ausgelegt ist, mehrere Spulen durch Kombinationen von Strömen gleichzeitig zu versorgen, um einen Gradienten X und/oder Y und/oder Z zu erzeugen, wobei n eine ganze Zahl größer oder gleich 3 ist.

11. Maschine nach Anspruch 10, die derart angeordnet ist, daß eine Komponente eines Stroms, der in einer Spule fließt, um einen Gradienten zu erzeugen, proportional zu einem Nennstrom multipliziert mit einem Kosinus eines Markierungswinkels der Spule auf dem Umfang des Ringraums ist.

12. Maschine nach einem der Ansprüche 1 bis 7, **dadurch gekennzeichnet, daß** der Ringraum (130) mehrere über den Umfang verteilte benachbarte Röhren umfaßt, um die Solenoidspulen aufzunehmen, wobei der Radius a einer Röhre durch a = r1(sin$\pi$/N)/(1-sin$\pi$/N) = r2(sin$\pi$/N)/(1+sin$\pi$/N) angegeben ist, Formel, worin N die Anzahl der Röhren sowie r1 und r2 den Innen- bzw. den Außenradius des Ringraums (130) darstellt.

13. Maschine nach einem der Ansprüche 1 bis 12, die derart angeordnet ist, daß Solenoidspulen durch Einzelstromversorgungen gespeist werden.

14. Maschine nach einem der Ansprüche 1 bis 13, **dadurch gekennzeichnet, daß** die Solenoidspulen von länglichen schraubenförmigen Windungen, vorzugsweise mit rechteckigem Profil, entlang von leitenden kreisförmigen Manschetten gebildet sind, wobei mehrere Manschetten einer gleichen Spule konzentrisch und ineinander gesteckt sind.

15. Maschine nach Anspruch 14, die derart angeordnet ist, daß ein Ringraum zwischen zwei Manschetten von einem Kühlmittel durchströmt wird.

EP 1 952 171 B1

FIG.1

FIG.2

FIG.3

FIG.4

FIG.5

FIG.6A

FIG.6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2588997
- FR 2621125
- US 5530355 A
- WO 2005029110 A
- EP 0681189 A
- US 20020105329 A